# EUROPÄISCHE PATENTSCHRIFT

(11) **EP 4 039 070 B1**
(45) Veröffentlichungstag und Bekanntmachung des Hinweises auf die Patenterteilung: **16.07.2025**
(21) Anmeldenummer: 20789512.9
(22) Anmeldetag: 02.10.2020
(51) Int. Cl.: H05K 7/14

(54) **ELEKTRISCHES GERÄT MIT EINER VERRIEGELUNGSEINRICHTUNG**
ELECTRICAL DEVICE HAVING A LOCKING DEVICE
DISPOSITIF ÉLECTRONIQUE COMPRENANT UN DISPOSITIF DE VERROUILLAGE

(30) Priorität: 02.10.2019 DE 102019126628
(43) Veröffentlichungstag der Anmeldung: 10.08.2022
(73) Patentinhaber: Phoenix Contact GmbH & Co. KG, 32825 Blomberg (DE)
(72) Erfinder: WERMTER, Peter, 32825 Blomberg (DE)
(74) Vertreter: Meyer-Graefe, Karsten
(86) Internationale Anmeldenummer: PCT/EP2020/077626
(87) Internationale Veröffentlichungsnummer: WO 2021/064158

(56) Entgegenhaltungen:
- WO-A1-2004/114466
- DE-U1- 9 400 887
- US-B1- 7 230 833

## Beschreibung

Die Erfindung betrifft ein elektrisches Gerät nach dem Oberbegriff des Anspruchs 1.

Ein solches elektrisches Gerät kann beispielsweise im Bereich der Automatisierungstechnik, beispielsweise in einer industriellen Anlage, zum Beispiel an einer Fertigungsanlage, zum Einsatz kommen. Ein solches elektrisches Gerät kann beispielsweise in einem Schaltschrank zu montieren sein und kann hierzu beispielsweise an einer Tragschiene innerhalb eines Schaltschranks oder an einer sonstigen Befestigungseinrichtung angeordnet werden. Ein solches elektrisches Gerät kann üblicherweise mit anderen elektrischen Geräten kombinierbar sein, beispielsweise indem elektrische Geräte aneinander angereiht werden, um auf diese Weise eine elektrische Funktionsgruppe für Automatisierungsfunktionen, zum Beispiel zum Steuern von Aktoren, zum Verarbeiten von Sensorsignalen und für eine Potenzialverteilung, zum Beispiel für eine elektrische Versorgung, zu schaffen.

Ein elektrisches Gerät der hier beschriebenen Art umfasst eine erste Gehäusebaugruppe und eine eine Gehäusewandung aufweisende, zweite Gehäusebaugruppe. Die Gehäusebaugruppen können aneinander angesetzt werden und sind in einer aneinander angesetzten Stellung über eine Verriegelungseinrichtung derart miteinander verriegelt, dass die Gehäusebaugruppen aneinander gehalten sind, durch Entriegeln der Verriegelungseinrichtung aber voneinander abgenommen werden können.

Bei einem solchen elektrischen Gerät sollen die Gehäusebaugruppen einfach aneinander angesetzt werden können und in einer angesetzten Stellung sicher und zuverlässig miteinander verriegeln. Eine Betätigung der Verriegelungseinrichtung zum Entriegeln soll hierbei einfach und komfortabel möglich sein, bei einfacher Bauform der Verriegelungseinrichtung.

Bei einem aus der DE 197 10 768 C2 bekannten elektrischen Gerät ist ein Sockel an eine Tragschiene ansetzbar. Mit dem Sockel kann eine Gehäusebaugruppe verbunden werden, wobei in verbundener Stellung eine elektrische Verbindung zwischen dem Sockel und der Gehäusebaugruppe besteht und die Gehäusebaugruppe zudem zum Sockel über einen Rasthaken verrastet ist.

Bei einem aus der DE 197 44 662 C1 bekannten elektrischen Gerät können Gehäusebaugruppen aneinander angesetzt werden und sind in einer verbundenen Stellung miteinander verrastet, wobei eine der Gehäusebaugruppen an einer Tragschiene zu befestigen ist und die andere der Gehäusebaugruppen beispielsweise Anschlüsse zum Anschließen von elektrischen Leitern aufweisen kann.

Des Weiteren betreffen DE 94 00 887 U1, US 7 230 833 81 sowie WO 2004/114466 A1 ein elektrisches Gerät, bei dem eine mittels eines Betätigungselements betätigbare Verriegelungsvorrichtung vorgesehen ist, die dazu dient, eine erste mit einer zweiten Gehäusebaugruppe zu verriegeln.

Aufgabe der vorliegenden Erfindung ist es, ein elektrisches Gerät zur Verfügung zu stellen, das eine einfache, komfortable, zuverlässige Verbindung von Gehäusebaugruppen miteinander ermöglicht, bei sicherem Halt in einer aneinander angesetzten Stellung und bei komfortabler Handhabung zum Lösen der Gehäusebaugruppen voneinander.

Diese Aufgabe wird durch einen Gegenstand mit den Merkmalen des Anspruchs 1 gelöst.

Demnach weist die Verriegelungseinrichtung ein entlang einer Betätigungsrichtung verstellbar an der zweiten Gehäusebaugruppe angeordnetes Betätigungselement und ein mit dem Betätigungselement wirkverbundenes, verstellbar mit der Gehäusewandung verbundenes Verriegelungselement auf. Das Verriegelungselement ist ausgebildet, in der aneinander angesetzten Stellung der Gehäusebaugruppen die erste Gehäusebaugruppe und die zweite Gehäusebaugruppe miteinander zu verriegeln. Das Verriegelungselement ist durch Verstellen des Betätigungselements in die Betätigungsrichtung zu der Gehäusewandung in eine quer zur Betätigungsrichtung gerichtete Entsperrrichtung zu der Gehäusewandung verstellbar, um die Verriegelung zu lösen.

Bei dem elektrischen Gerät wird eine Verriegelung der Gehäusebaugruppen miteinander in einer aneinander angesetzten Stellung über die Verriegelungseinrichtung hergestellt, die hierzu ein an der zweiten Gehäusebaugruppe angeordnetes Betätigungselement und ein ebenfalls an der zweiten Gehäusebaugruppe angeordnetes Verrieglungselement aufweist. Das Verriegelungselement dient dazu, in der aneinander angesetzten Stellung der Gehäusebaugruppen eine Verriegelung herzustellen, indem das Verriegelungselement eine Wirkverbindung zwischen den Gehäusebaugruppen schafft und somit die Gehäusebaugruppen zueinander festlegt.

Das Verriegelungselement kann hierbei vorzugsweise selbsttätig eine Stellung an der Gehäusewandung der zweiten Gehäusebaugruppe einnehmen, die einer Verrieglungsstellung entspricht, sodass bei Ansetzen der Gehäusebaugruppen aneinander das Verriegelungselement selbsttätig verriegelt und somit bei Ansetzen der Gehäusebaugruppen aneinander automatisch eine Verbindung zwischen den Gehäusebaugruppen hergestellt wird.

Das Verrieglungselement kann durch Betätigung des Betätigungselements entriegelt werden, indem bei Verstellen des Betätigungselements in die Betätigungsrichtung das Verriegelungselement in eine quer zur Betätigungsrichtung gerichtete Entsperrrichtung an der Gehäusewandung bewegt wird. Auf diese Weise kann die Verriegelung zwischen den Gehäusebaugruppen aufgehoben werden, sodass die Gehäusebaugruppen voneinander abgenommen und dadurch voneinander getrennt werden können.

Des Weiteren ist das Verriegelungselement einstückig mit der Gehäusewandung geformt und als Lasche an der Gehäusewandung geformt, wobei das Verriegelungselement vorzugsweise elastisch zu der Gehäusewandung verstellbar ist. In einer Ausgangsstellung bei nicht betätigtem Betätigungselement nimmt das Verriegelungselement eine Stellung ein, in der die Gehäusebaugruppe über das Verriegelungselement miteinander verriegelt werden können. Bei Ansetzen der Gehäusebaugruppen aneinander verriegelt die Verriegelungseinrichtung somit automatisch, sodass eine sichere und zuverlässige Verbindung zwischen den Gehäusebaugruppen hergestellt wird.

Dadurch, dass das Verriegelungselement einstückig als Lasche mit der Gehäusewandung und somit mit der zweiten Gehäusebaugruppe geformt ist, ergibt sich eine einfache Fertigung, im Rahmen derer das Verriegelungselement gemeinsam mit der Gehäusewandung gefertigt wird. Die Gehäusewandung kann beispielsweise als Kunststoffformteil, zum Beispiel mittels Kunststoffspritzgießen, gefertigt sein, wobei das Verriegelungselement in einem Arbeitsgang mit der Gehäusewandung geformt wird.

Zudem weist das Betätigungselement erfindungsgemäß zwei Wirkabschnitte auf, die an parallel zueinander erstreckten Seitenkanten des Verriegelungselements verschiebbar geführt sind.

In einer Ausgestaltung nimmt das Verriegelungselement in einer Verriegelungsstellung eine erste Stellung zu der Gehäusewandung ein und steht beispielsweise nach außen von der Gehäusewandung vor. Durch Verstellen des Betätigungselements ist das Verriegelungselement in eine Entriegelungsstellung verstellbar, in der das Verrieglungselement relativ zur Verriegelungsstellung in die Entsperrrichtung nach innen bewegt ist. In der Verriegelungsstellung, in der das Verriegelungselement bei Ansetzen der Gehäusebaugruppen aneinander verriegeln kann, nimmt das Verriegelungselement eine solche Stellung zu der Gehäusewandung ein, dass das Verriegelungselement bei Ansetzen der Gehäusebaugruppen aneinander mit einem zugeordneten Verriegelungsabschnitt an der anderen, ersten Gehäusebaugruppe in Eingriff gelangen kann, sodass auf diese Weise eine Verriegelung zwischen den Gehäusebaugruppen hergestellt werden kann. Aus der Verriegelungsstellung ist das Verriegelungselement verstellbar, indem das Betätigungselement betätigt wird, wobei in der Entriegelungsstellung das Verriegelungselement so nach innen in Richtung des Gehäuseinneren der zweiten Gehäusebaugruppe verstellt ist, dass die verriegelnde Verbindung zwischen den Gehäusebaugruppen aufgehoben ist und die Gehäusebaugruppen aus ihrer aneinander angesetzten Stellung gelöst und voneinander abgenommen werden können. Das Verstellen des Verrieglungselements an der Gehäusewandung erfolgt hierbei in die quer zur Betätigungsrichtung gerichtete Entsperrrichtung.

In einer Ausgestaltung ist das Verriegelungselement an einem verbundenen Ende mit der Gehäusewandung verbunden. Ist das Verriegelungselement einstückig und integral mit der Gehäusewandung geformt, so ist das Verriegelungselement an dem verbundenen Ende integral mit der Gehäusewandung geformt und geht an dem verbundenen Ende in die Gehäusewandung über. Insbesondere im Bereich des verbundenen Endes ist das Verriegelungselement hierbei elastisch zum Verstellen gegenüber der Gehäusewandung verformbar, sodass durch Betätigung des Betätigungselements das Verriegelungselement zu der Gehäusewandung verstellt werden kann.

In der Verriegelungsstellung ist das Verriegelungselement über eine von dem verbundenen Ende abliegende Endkante mit der ersten Gehäusebaugruppe verriegelbar, indem die Endkante verriegelnd in Eingriff mit einem zugeordneten Verriegelungsabschnitt der ersten Gehäusebaugruppe bringbar ist.

In einer Ausgestaltung weist das Betätigungselement eine Sperrabschnitt auf, der in der Verriegelungsstellung mit der Endkante derart wechselwirkt, dass der Sperrabschnitt ein Bewegen der Endkante in die Entsperrrichtung relativ zu der Gehäusewandung sperrt. Der Sperrabschnitt des Betätigungselements dient somit dazu, das Verriegelungselement in der Verriegelungsstellung zu sichern, sodass das Verriegelungselement nicht ohne weiteres, jedenfalls nicht ohne Betätigung des Betätigungselements, aus der Verriegelungsstellung herausgebracht werden kann. Durch eine solche Sperrwirkung kann die verriegelte Verbindung zwischen den Gehäusebaugruppen gesichert werden. Über den Sperrabschnitt kann zudem einer Funktionsbeeinträchtigung zum Beispiel aufgrund einer Deformation oder einem Verschleiß an dem Verrieglungselement entgegengewirkt werden.

Zum Sperren ist der Sperrabschnitt, in einer Ausgestaltung, vorzugsweise hinter der Endkante angeordnet (betrachtet in die Entsperrrichtung), sodass der Sperrabschnitt eine Bewegung der Endkante in die Entsperrrichtung sperrt. Der Sperrabschnitt untergreift somit die Endkante, sodass darüber einem Verstellen des Verriegelungselements in die Entriegelungsstellung entgegengewirkt ist.

Der Sperrabschnitt ist beispielsweise integral an dem Betätigungselement geformt und durch eine Kante an dem Betätigungselement ausgebildet. Der Sperrabschnitt kann durch Verstellen des Betätigungselements relativ zu der Endkante des Verriegelungselements bewegbar sein, sodass bei einem Betätigen des Betätigungselements der Sperrabschnitt aus seiner Wirkverbindung mit der Endkante des Verriegelungselements bewegt wird und somit die Sperrwirkung aufgehoben ist.

In einer Ausgestaltung ist an dem Sperrabschnitt an einer entgegen der Betätigungsrichtung weisenden Stirnseite eine Fase geformt, die durch einen schräg zur Betätigungsrichtung und schräg zur Entsperrrichtung geformten Flächenabschnitt an der Stirnseite gebildet ist. Die Fase dient dazu, bei einem Zurückstellen des Betätigungselements entgegen der Betätigungsrichtung ein Herstellen der Wirkverbindung zwischen dem Sperrabschnitt und der Endkante des Verriegelungselements zu vereinfachen, indem der Sperrabschnitt bei Zurückstellen des Betätigungselements entgegen der Betätigungsrichtung hinter die Endkante gleiten kann, gegebenenfalls unter Auflaufen der Endkante auf die Fase des Sperrabschnitts.

In einer Ausgestaltung ist das Betätigungselement entlang der Betätigungsrichtung linear verschiebbar an der zweiten Gehäusebaugruppe geführt. Das Betätigungselement kann zur Betätigung somit an der zweiten Gehäusebaugruppe verschoben werden, sodass dadurch das Verriegelungselement zu der Gehäusewandung bewegt und eine Verriegelung der Gehäusebaugruppen miteinander aufgehoben wird.

In einer Ausgestaltung ist die Betätigungsrichtung, in die das Betätigungselement zum Entriegeln der Gehäusebaugruppen voneinander bewegbar ist, hierbei einer Steckrichtung, in die die zweite Gehäusebaugruppe an die erste Gehäusebaugruppe zum Verbinden angesetzt werden kann, entgegengerichtet. Dies ermöglicht, ein Lösen der Verriegelung und ein Abnehmen der zweiten Gehäusebaugruppe von der ersten Gehäusebaugruppe in einem Bewegungsablauf vorzunehmen, indem zum Lösen der Verriegelung ein Nutzer beispielsweise an dem Betätigungselement in die Betätigungsrichtung zieht, dadurch die Verriegelung löst und nach Lösen der Verriegelung die zweite Gehäusebaugruppe in die Betätigungsrichtung, also entgegen der Steckrichtung, von der ersten Gehäusebaugruppe abnimmt. Dies erleichtert die Handhabung zum Entriegeln und zum Lösen der Gehäusebaugruppen voneinander insbesondere auch dadurch, dass keine separaten Bewegungsabläufe zum Lösen der Verriegelung und zum Trennen der Gehäusebaugruppen voneinander erforderlich sind, was insbesondere auch ermöglicht, dass das Betätigungselement nicht umständlich in der Entriegelungsstellung gehalten werden muss, bis die Gehäusebaugruppen voneinander gelöst sind, sondern das Lösen der Verriegelung und das Abnehmen der Gehäusebaugruppen voneinander in einem intuitiven, einfachen Ablauf erfolgen kann. Insbesondere wird dadurch auch eine eigenhändige Bedienung möglich.

Die erste Gehäusebaugruppe kann beispielsweise an einer Tragschiene zu befestigen sein und hierzu eine geeignete Befestigungseinrichtung zum rastenden Verbinden mit der Tragschiene, zum Beispiel einer sogenannten Hutschiene, aufweisen. Die Steckrichtung, in die die zweite Gehäusebaugruppe an die erste Gehäusebaugruppe angesetzt werden kann, kann hierbei in Richtung der Tragschiene gerichtet sein, sodass die zweite Gehäusebaugruppe bei mit der Tragschiene verbundener, erster Gehäusebaugruppe steckend mit der ersten Gehäusebaugruppe verbunden werden kann.

Erfindungsgemäß weist das Betätigungselement zumindest einen Wirkabschnitt auf, der an zumindest einer Seitenkante des Verriegelungselements verschiebbar, insbesondere linear verschiebbar, geführt ist. Beispielsweise kann das Betätigungselement zwei Wirkabschnitte aufweisen, die an parallel zueinander erstreckten Seitenkanten, beispielsweise an voneinander abliegenden, äußeren Kanten des Verriegelungselements oder an einander zugewandten Kanten eines Schlitzes des Verriegelungselements geführt, insbesondere linear verschiebbar geführt sind. Die Wirkabschnitte können beispielsweise als Gleitabschnitte ausgebildet sein, die gleitend an den Seitenkanten bewegbar sind und bei Betätigung des Betätigungselements in die Betätigungsrichtung so auf die Seitenkanten auflaufen, dass das Verriegelungselement in die Entsperrrichtung zum Entriegeln der Verbindung zwischen den Gehäusebaugruppen bewegt wird. Über die Wirkabschnitte erfolgt somit eine Kraftumlenkung der Bewegung des Verriegelungselements in die Betätigungsrichtung in eine Bewegung des Verriegelungselements in die quer zur Betätigungsrichtung gerichtete Entsperrrichtung, indem die Wirkabschnitte bei Betätigung des Betätigungselements auf die Seitenkanten an dem Verriegelungselement auflaufen und das Verriegelungselement dadurch in die Entsperrrichtung verstellen.

In einer Ausgestaltung ist an der zweiten Gehäusebaugruppe ein Federelement angeordnet, das das Betätigungselement gegenüber der zweiten Gehäusebaugruppe entgegen der Betätigungsrichtung vorspannt. Ein Betätigen des Betätigungselements zum Entriegeln der Gehäusebaugruppen voneinander erfolgt somit entgegen der Federvorspannung des Federelements, das beispielsweise als Zugfeder oder Druckfeder ausgestaltet sein kann. Nach erfolgter Betätigung wird das Betätigungselement aufgrund der Federwirkung des Federelements selbsttätig in eine nicht betätigte Ausgangsstellung zurückgestellt, in der das Verriegelungselement die Verriegelungsstellung einnimmt und somit die Gehäusebaugruppen bei Ansetzen aneinander miteinander verriegeln können.

Das Federelement kann beispielsweise in einer zugeordneten Aussparung an dem Betätigungselement aufgenommen sein und eine Federvorspannung zwischen dem Betätigungselement und der Gehäusewandung der zweiten Gehäusebaugruppe bewirken.

In einer Ausgestaltung weist die erste Gehäusebaugruppe, die beispielsweise durch ein an eine Tragschiene ansetzbares Sockelgehäuse ausgebildet sein kann, eine Stecköffnung auf, in die die zweite Gehäusebaugruppe mit einem Steckabschnitt eingesteckt werden kann. In der aneinander angesetzten Stellung ist der Steckabschnitt in der Stecköffnung aufgenommen, sodass die Gehäusebaugruppe darüber miteinander verbunden sind.

Das Verriegelungselement kann an dem Steckabschnitt geformt sein, wobei in diesem Fall die Gehäusewandung, an der das Verriegelungselement angeordnet ist, sich an dem Steckabschnitt erstreckt und beispielsweise durch eine Längswandung der zweiten Gehäusebaugruppe ausgebildet ist (die länger ist als eine stirnseitige, kurze Wandung der zweiten Gehäusebaugruppe).

In einer Ausgestaltung weist die erste Gehäusebaugruppe eine der Stecköffnung zugewandte Wandung und einen an der Wandung geformten Rastabschnitt auf, zum Beispiel in Form einer Rastnase, mit der das Verriegelungselement in der aneinander angesetzten Stellung der Gehäusebaugruppen zum Verriegeln in Eingriff ist. Beim Ansetzen der Gehäusebaugruppen aneinander gleitet das Verriegelungselement beispielsweise über den Rastabschnitt und eine darin geformte Auflaufschräge, sodass beim steckenden Verbinden der Gehäusebaugruppen miteinander das Verriegelungselement selbsttätig zum Verriegeln mit dem Rastabschnitt in Eingriff gelangt. In der Verriegelungsstellung ist das Verriegelungselement formschlüssig mit dem Rastabschnitt in Eingriff, sodass darüber die Gehäusebaugruppen entgegen der Steckrichtung zueinander festgelegt sind. Durch Betätigen des Betätigungselements kann das Verriegelungselement in die quer zur Betätigungsrichtung gerichtete Entsperrrichtung außer Eingriff von dem Rastabschnitt gezogen werden, sodass die Gehäusebaugruppe wieder voneinander gelöst werden können.

Ein Ansetzen der Gehäusebaugruppen aneinander kann bei nicht betätigtem Betätigungselement erfolgen. Hierzu weisen die Gehäusewandung der zweiten Gehäusebaugruppe und/oder die Wandung der ersten Gehäusebaugruppe, an der der Rastabschnitt geformt ist, eine hinreichende Elastizität auf, sodass das Verriegelungselement der zweiten Gehäusebaugruppe bei Ansetzen der Gehäusebaugruppen aneinander auch bei nicht betätigtem Betätigungselement an dem Rastabschnitt der ersten Gehäusebaugruppe vorbei bewegt werden kann, um mit dem Rastabschnitt formschlüssig in Eingriff zu schnappen.

Das Betätigungselement weist, in einer Ausgestaltung, einen Kopf auf, der im Bereich einer von dem Steckabschnitt abgewandten Kopfseite der zweiten Gehäusebaugruppe angeordnet ist. Der Kopf des Betätigungselements kann dadurch von einer dem Steckabschnitt abgewandten Seite der zweiten Gehäusebaugruppe zugänglich sein, sodass das Betätigungselement durch Angreifen an dem Kopf betätigt und dadurch die Verriegelung zwischen den Gehäusebaugruppen aufgehoben werden kann.

Ein elektrisches Gerät der vorangehend beschriebenen Art kann insbesondere eine Automatisierungsfunktion übernehmen, zum Beispiel im Rahmen einer industriellen Anlage oder im Bereich der Gebäudeautomatisation. Ein elektrisches Gerät der beschriebenen Art kann beispielsweise in einem Schaltschrank zu montieren sein, wobei hierzu beispielsweise die erste Gehäusebaugruppe an einer Tragschiene festzulegen sein kann, sodass das elektrische Gerät insgesamt an einer Tragschiene angeordnet und gegebenenfalls mit weiteren elektrischen Geräten kombiniert werden kann.

Denkbar ist aber auch, das elektrische Gerät unabhängig von einer Tragschiene zu verwenden, beispielsweise indem das elektrische Gerät an einer Wandung eines Schaltschranks zu befestigen ist.

Der der Erfindung zugrunde liegende Gedanke soll nachfolgend anhand der in den Figuren dargestellten Ausführungsbeispiele näher erläutert werden. Es zeigen:
- Fig. 1: eine Ansicht eines Ausführungsbeispiels eines elektrischen Geräts, das unterschiedliche Gehäusebaugruppen aufweist, die steckend miteinander verbunden werden können.
- Fig. 2: eine Seitenansicht der Anordnung gemäß Fig. 1;
- Fig. 3: eine Schnittansicht entlang der Linie A-A gemäß Fig. 2;
- Fig. 4: eine Schnittansicht entlang der Linie B-B gemäß Fig. 2;
- Fig. 5: eine andere Ansicht des elektrischen Geräts, in einer aneinander angesetzten Stellung zweier Gehäusebaugruppen;
- Fig. 6: eine Ansicht der Anordnung gemäß Fig. 5, bei voneinander getrennten Gehäusebaugruppen;
- Fig. 7: eine gesonderte Ansicht einer der Gehäusebaugruppen;
- Fig. 8: die Gehäusebaugruppe gemäß Fig. 7, in einer teiltransparenten Ansicht;
- Fig. 9: eine Ansicht der Gehäusebaugruppe gemäß Fig. 7, in einer betätigten Stellung eines Betätigungselements;
- Fig. 10: die Gehäusebaugruppe gemäß Fig. 9, in einer teiltransparenten Ansicht;
- Fig. 11: eine gesonderte Ansicht einer Gehäusewandung und des daran angeordneten Betätigungselements;
- Fig. 12: eine Schnittansicht entlang der Linie A-A gemäß Fig. 11, in einer Verriegelungsstellung;
- Fig. 13: eine Schnittansicht entlang der Linie B-B gemäß Fig. 11, in der Verriegelungsstellung;
- Fig. 14: eine Schnittansicht entlang der Linie B-B gemäß Fig. 11, in einer betätigten Stellung des Betätigungselements;
- Fig. 15: eine Schnittansicht entlang der Linie A-A gemäß Fig. 11, in der betätigten Stellung des Betätigungselements;
- Fig. 16: eine Schnittansicht eines Ausführungsbeispiels, bei dem das Betätigungselement über ein Federelement federvorgespannt ist, in der Verriegelungsstellung; und
- Fig. 17: die Schnittansicht gemäß Fig. 16, in der betätigten Stellung des Betätigungselements.

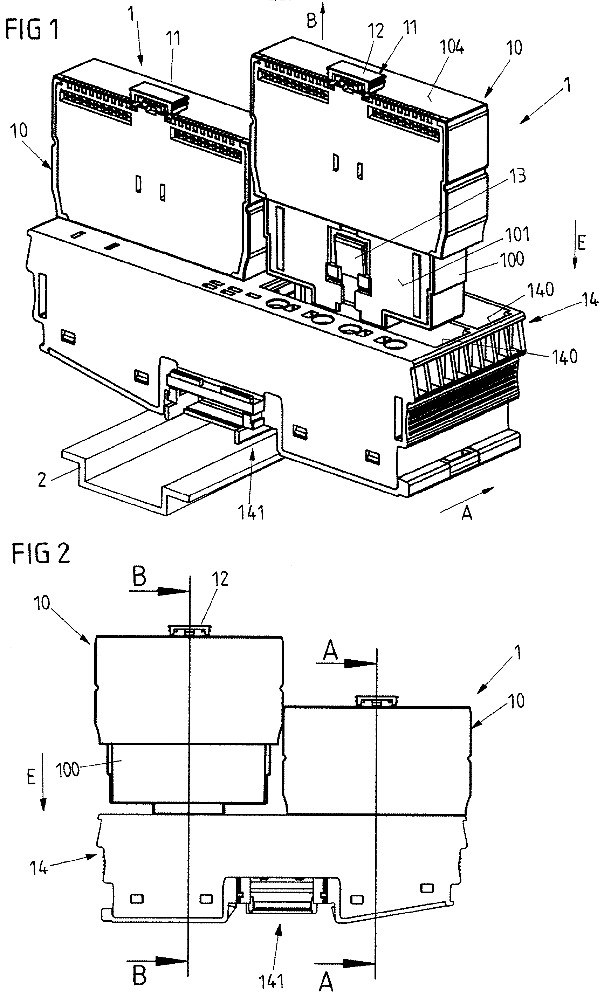

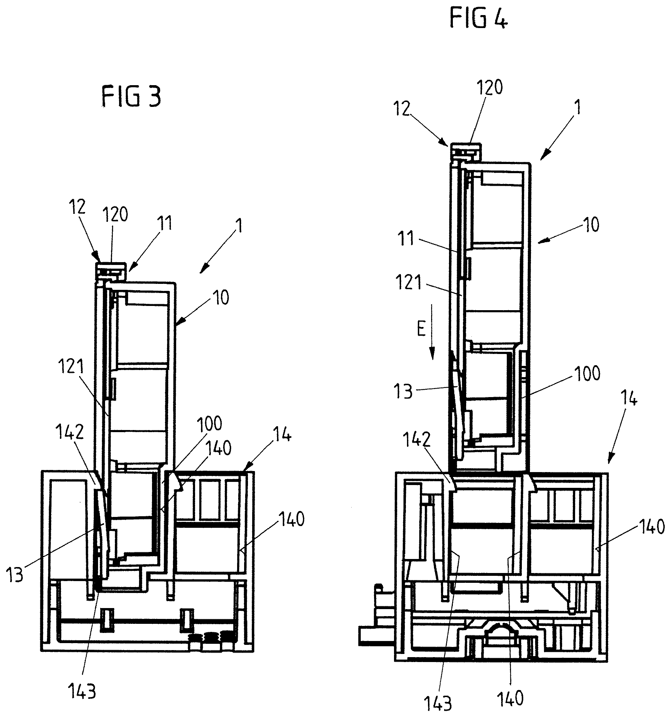

Bei einem in Fig. 1 bis 4 dargestellten Ausführungsbeispiel eines elektrischen Geräts 1 kann eine Gehäusebaugruppe 14 in Form eines Gehäusesockels über eine Befestigungseinrichtung 141 an einer Tragschiene 2 angeordnet und an der Tragschiene 2 zum Beispiel entlang einer Anreihrichtung A mit anderen elektrischen Geräten gleicher oder anderer Bauform kombiniert werden, um auf diese Weise eine elektrische Funktionsbaugruppe zu schaffen, die zum Beispiel Automatisierungsfunktionen im Bereich einer Industrieanlage oder der Gebäudeautomatisation übernehmen kann.

Die Gehäusebaugruppe 14 stellt einen Gehäusesockel dar, der beispielsweise Anschlüsse zum Anschließen von elektrischen Leitungen aufweisen kann. An der Gehäusebaugruppe 14 sind, bei dem dargestellten Ausführungsbeispiel, mehrere Stecköffnungen 140 (bei dem dargestellten Ausführungsbeispiel vier Stecköffnungen 140) geformt, in die modulare Gehäusebaugruppen 10 eingesteckt werden können, um die Gehäusebaugruppen 10 mit der Gehäusebaugruppe 14 mechanisch zu verbinden und elektrisch zu kontaktieren.

Die Gehäusebaugruppen 10 können beispielsweise jeweils eine Elektronik enthalten, sodass durch Ansetzen an die Gehäusebaugruppe 14 in Form des Gehäusesockels in modularer Weise unterschiedliche elektrische und/oder elektronische Funktionen an dem elektrischen Gerät 1 zur Verfügung gestellt werden können.

Die Gehäusebaugruppen 10 weisen jeweils einen Steckabschnitt 100 auf, mit dem die jeweilige Gehäusebaugruppe 10 in eine zugeordnete Stecköffnung 140 an der Gehäusebaugruppe 14 entlang einer Steckrichtung E eingesteckt werden kann, um auf diese Weise die Gehäusebaugruppe 10 mit der Gehäusebaugruppe 14 zu verbinden.

Eine jede Gehäusebaugruppe 10 weist eine Verriegelungseinrichtung 11 auf, die dazu dient, die Gehäusebaugruppe 10 in einer an die Gehäusebaugruppe 14 angesetzten Stellung mit der Gehäusebaugruppe 14 so zu verriegeln, dass die Gehäusebaugruppe 10 formschlüssig entgegen der Steckrichtung E zu der Gehäusebaugruppe 14 festgelegt und somit mechanisch an der Gehäusebaugruppe 14 gehalten ist. Die Verriegelungseinrichtung 11 ist lösbar, um die Gehäusebaugruppe 10 entgegen der Steckrichtung E von der Gehäusebaugruppe 14 abzunehmen.

Zur Ausbildung der Verriegelungseinrichtung 11 ist an der Gehäusebaugruppe 10 ein Verriegelungselement 13 angeordnet, das einstückig und integral mit einer Gehäusewandung 101 der Gehäusebaugruppe 10 geformt ist und mit einem entlang einer Betätigungsrichtung B zu der Gehäusewandung 101 verschiebbaren Betätigungselement 12 in Wirkverbindung steht.

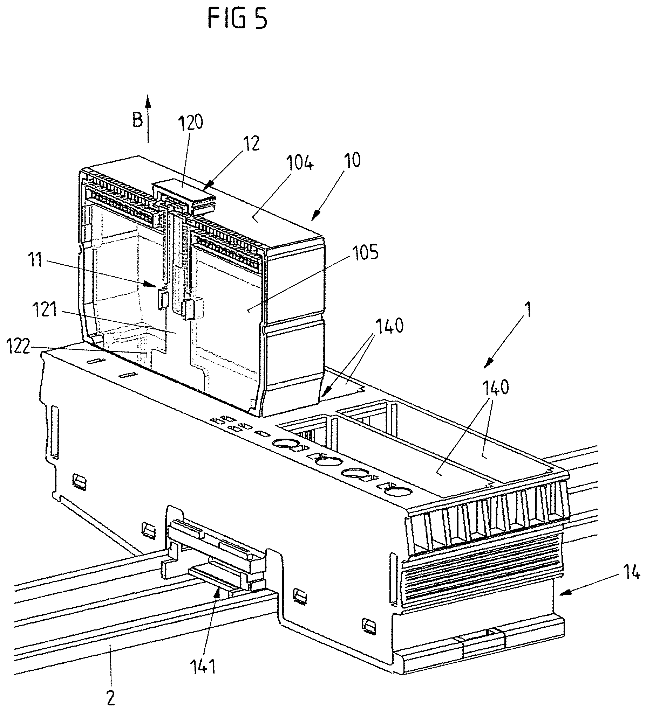

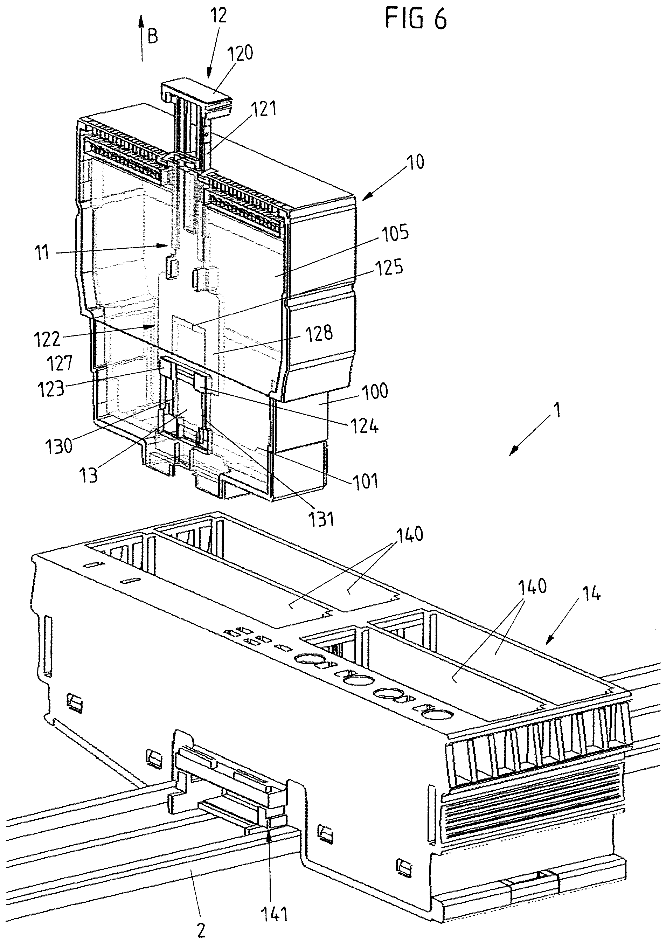

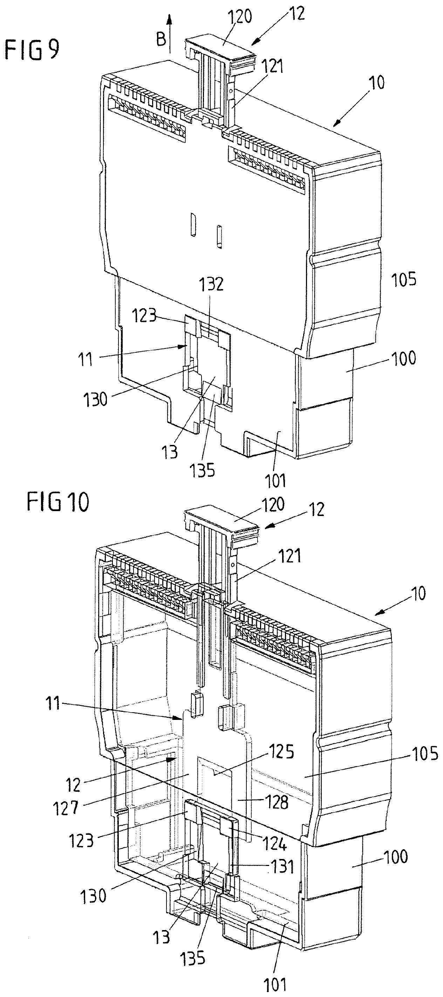

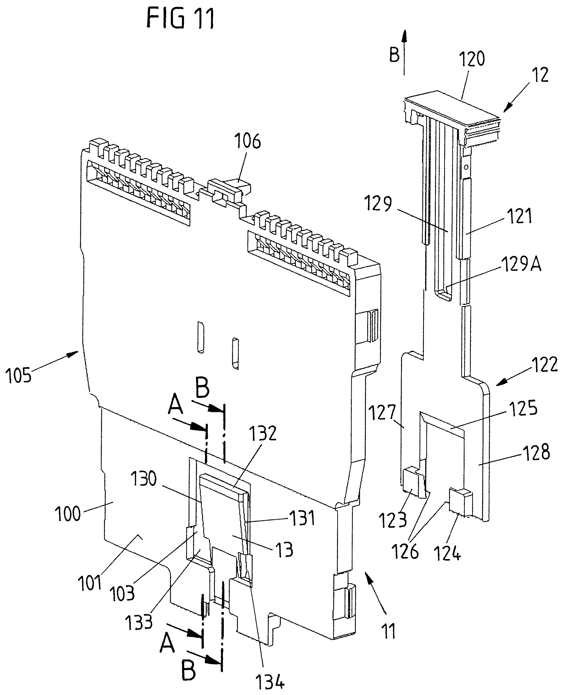

Bezugnehmend auf Fig. 5 bis 15 weist das Betätigungselement 12 einen Betätigungskopf 120 auf, der im Bereich einer von dem Steckabschnitt 100 abgewandten Kopfseite 104 der jeweils zugeordneten Gehäusebaugruppe 10 angeordnet ist, wie dies beispielsweise aus Fig. 5 ersichtlich ist. Der Kopf 120 ist an einem Schaftabschnitt 121 geformt, der an einem von dem Kopf 120 abliegenden Ende einen Fußabschnitt 122 ausbildet, der durch Schenkel 127, 128 und an den Schenkeln geformte Wirkabschnitte 123, 124 geformt ist, wie dies beispielsweise aus Fig. 11 ersichtlich ist.

Das Betätigungselement 12 ist entlang der Betätigungsrichtung B linear verschiebbar an der Gehäusewandung 101, die durch ein mit einem Gehäusekasten zu verbindenden Gehäuseteil 105 der Gehäusebaugruppe 10 verwirklicht ist, geführt. Über die Wirkabschnitte 123, 124 des Fußabschnitts 122 ist das Betätigungselement 12 in Wirkverbindung mit dem im Bereich des Steckabschnitts 100 an der Gehäusewandung 101 geformten Verriegelungselement 13, das - wie aus Fig. 11 ersichtlich - integral mit der Gehäusewandung 101 geformt ist, dazu an einem verbundenen Ende 135 mit der Gehäusewandung 101 verbunden ist und mit einer Endkante 132 von dem verbundenen Ende 135 abliegt. Das Verriegelungselement 13 ist innerhalb einer Aussparung 103 der Gehäusewandung 101 angeordnet und innerhalb der Öffnung 103 elastisch zu der Gehäusewandung 101 verstellbar.

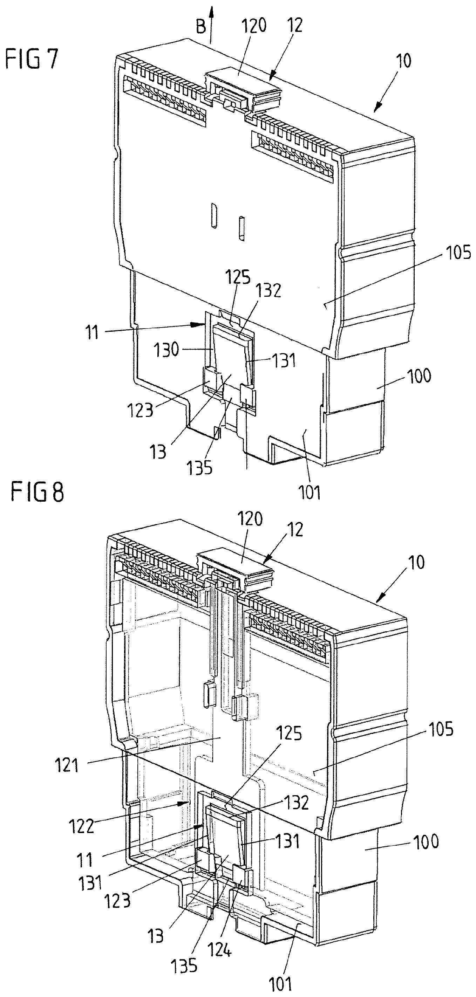

Wie aus Fig. 7, 8 und Fig. 9, 10 ersichtlich, gleiten die Wirkabschnitte 123, 124 des Betätigungselements 12 an Seitenkanten 130, 131 des Verriegelungselements 13. An unteren, dem verbundenen Ende 135 zugewandten Enden der Seitenkanten 130, 131 sind hierbei Aussparungen 133, 134 an dem Verrieglungselement 13 geformt, die ein Montieren des Betätigungselements 12 unter Herstellen der Wirkverbindung zwischen den Wirkabschnitten 123, 124 und dem Verriegelungselement 13 ermöglichen.

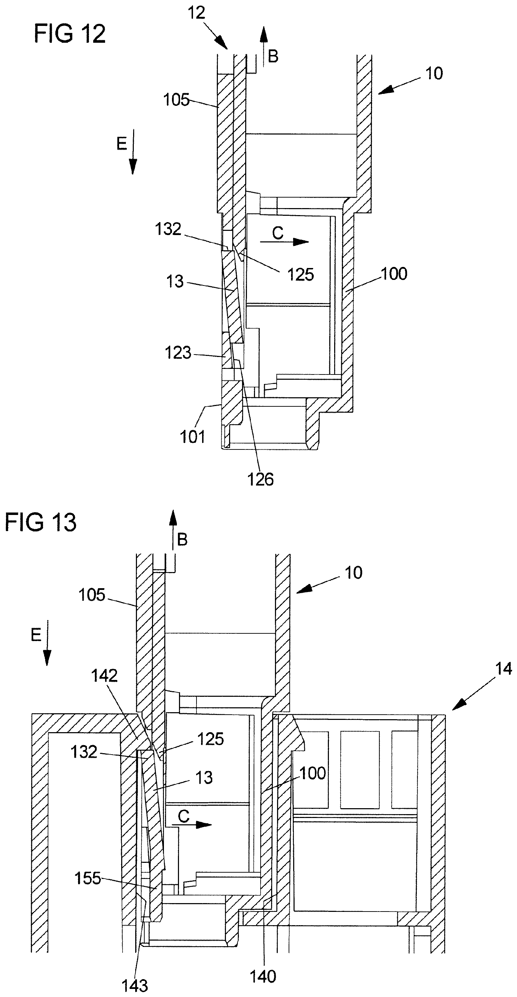

Wie aus den Schnittansichten gemäß Fig. 12 und 13 ersichtlich, ist das Verriegelungselement 13 in einer Verriegelungsstellung schräg zur Gehäusewandung 101 gestellt und weist mit seiner freien Endkante 132 nach außen. In der Verriegelungsstellung kann über das Verriegelungselement 13 eine Verriegelung mit einem Rastabschnitt 142 an einer Wandung 143 innerhalb der Stecköffnung 140 der Gehäusebaugruppe 14 hergestellt werden, indem bei Einstecken der Gehäusebaugruppe 10 in die Steckrichtung E in eine zugeordnete Stecköffnung 140 der Gehäusebaugruppe 14 das Verriegelungselement 13 auf den Rastabschnitt 142 aufläuft und nach Passieren des Rastabschnitts 142 mit dem Rastabschnitt 142 in Eingriff schnappt, wie dies insbesondere aus Fig. 13 ersichtlich ist. In der Verriegelungsstellung ist bei aneinander angesetzten Gehäusebaugruppen 10, 14 somit eine formschlüssige Verbindung zwischen den Gehäusebaugruppen 10, 14 hergestellt, sodass die Gehäusebaugruppen 10, 14 entgegen der Steckrichtung E zueinander festgelegt sind.

Wie dies aus Fig. 12 und 13 in Zusammenschau mit Fig. 11 ersichtlich ist, bildet das Betätigungselement 12 an dem Fußabschnitt 122 zwischen den Schenkeln 127, 128 einen Sperrabschnitt 125 aus, der in der Verriegelungsstellung des Betätigungselements 12 das Verriegelungselement 13 so untergreift, dass das Verriegelungselement 13 in eine Entsperrrichtung C gesperrt ist. Der Sperrabschnitt 125 kommt in die Entsperrrichtung C hinter der Endkante 132 des Verriegelungsrahmens 13 zu liegen, sodass das Betätigungselement 12 das Verriegelungselement 13 entgegen der Entsperrrichtung C abstützt und somit in der Verriegelungsstellung hält.

An dem Sperrabschnitt 125 ist eine Fase geformt die schräg zur Betätigungsrichtung B und zur Entsperrrichtung C gerichtet ist. Mit der Fase kann der Sperrabschnitt 125 auf die Endkante 132 auflaufen, wenn das Betätigungselement 12 in die verriegelnde Stellung verstellt wird, sodass darüber eine Abstützung des Sperrabschnitts 125 zu der Endkante 132 des Verriegelungselements 13 geschaffen werden kann.

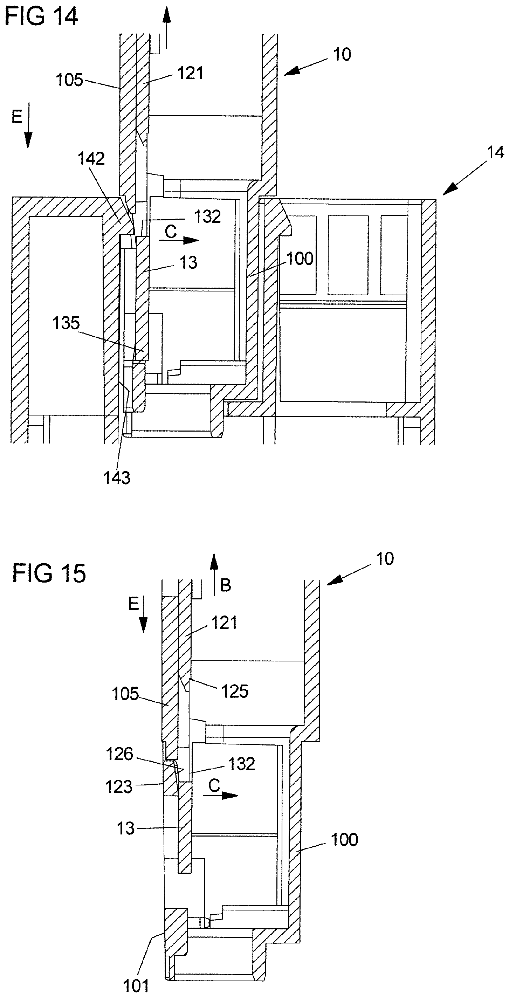

Durch Betätigung des Betätigungselements 12 in die Betätigungsrichtung B kann das Verriegelungselement 13 entriegelt werden. Die Wirkabschnitte 123, 124 gleiten bei Betätigung des Betätigungselements 12 mit je einer innenseitig des jeweiligen Wirkabschnitts 123, 124 geformten Fase 126 (siehe Fig. 11) an den Seitenkanten 130, 131 des Verriegelungselements 13 und verstellen dadurch das Verriegelungselement 13 in die Entsperrrichtung C elastisch zu der Gehäusewandung 101 nach innen, wie dies im Übergang von Fig. 12, 13 hin zu Fig. 14, 15 ersichtlich ist. Dadurch wird, wie aus Fig. 14 ersichtlich, die Endkante 132 des Verriegelungselements 13 außer Eingriff von dem Rastabschnitt 142 an der Wandung 143 der Gehäusebaugruppe 14 gebracht, sodass die Gehäusebaugruppen 10, 14 entgegen der Steckrichtung E voneinander abgenommen werden können.

Die Betätigungsrichtung B, in die das Betätigungselement 12 zum Entriegeln der Verriegelungseinrichtung 11 zu betätigen ist, ist entgegen der Steckrichtung E gerichtet. Zum Betätigen des Betätigungselements 12 kann ein Nutzer beispielsweise an dem Kopf 120 des Betätigungselements 12 ziehen, um auf diese Weise das Betätigungselement 12 in die Betätigungsrichtung B an der Gehäusebaugruppe 10 zu verschieben. Das Abnehmen der Gehäusebaugruppe 10 von der Gehäusebaugruppe 14 erfolgt dann in die Betätigungsrichtung B, sodass das Betätigen des Betätigungselements 12 und das Entnehmen der Gehäusebaugruppe 10 von der Gehäusebaugruppe 14 in einem Bewegungsablauf und somit einem Arbeitsgang erfolgen kann.

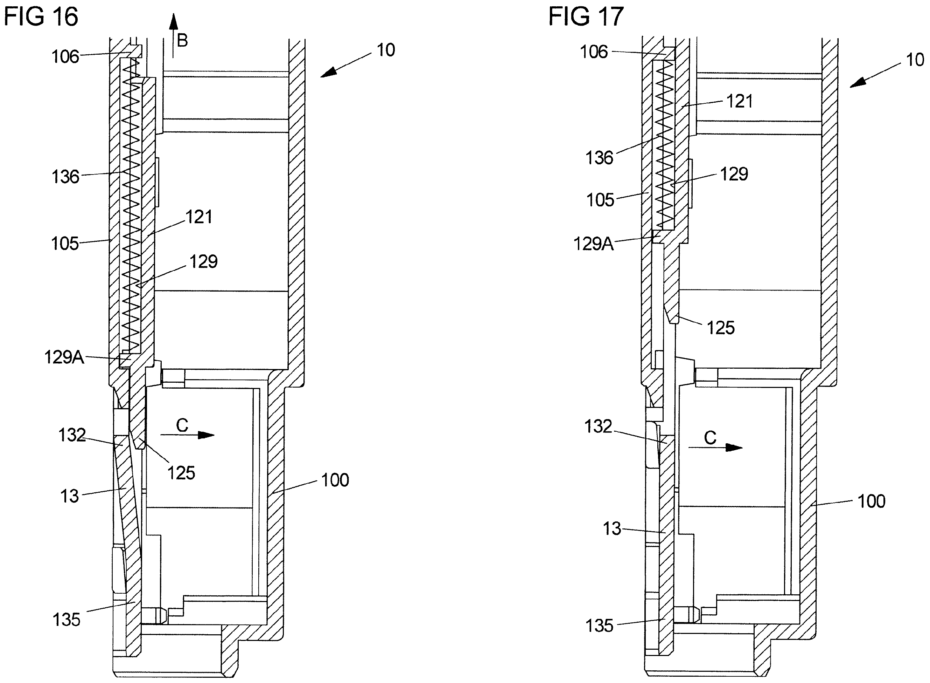

Das Betätigungselement 12 kann, wie in einem Ausführungsbeispiel in Fig. 16 und 17 dargestellt, über ein Federelement 136 zu der Gehäusebaugruppe 10 federelastisch vorgespannt sein. Das Federelement 136 kann hierzu beispielsweise in einer Aussparung 129 in Form einer Aufnahmenut an dem Schaftabschnitt 121 des Betätigungselements 12 aufgenommen und mit einem Ende an einem Boden 129A der Aussparung 129 am Übergang zu dem Fußabschnitt 122 und mit dem anderen Ende an einem Stützabschnitt 106 abgestützt sein, der an dem Gehäuseteil 105 geformt ist und als Vorsprung in die Aussparung 129 in Form der Aufnahmenut eingreift.

Bei dem dargestellten Ausführungsbeispiel ist das Federelement 136 als Druckfeder ausgebildet und spannt das Betätigungselement 12 in Richtung der Verriegelungsstellung (Fig. 16) vor. Bei einem Verstellen des Betätigungselements 12 zum Entriegeln in die Betätigungsrichtung B wird das Federelement 136 auf Druck gespannt (Fig. 17), bedingt durch eine Abstandsänderung zwischen dem Boden 129A der Aussparung 129 und dem Stützabschnitt 106 am Gehäuseteil 105 entlang der Betätigungsrichtung B. Die Spannung an dem Federelement 136 bewirkt, dass nach erfolgter Betätigung das Betätigungselement 12 entgegen der Betätigungsrichtung B selbsttätig in die Verriegelungsstellung (Fig. 16) zurückgestellt wird.

Dies ermöglicht, dass das Betätigungselement 12 nach erfolgter Betätigung selbsttätig zurück in seine der Verriegelungsstellung des Verriegelungselements 13 zugeordnete Ausgangsstellung gelangt, das Betätigungselement 12 nach erfolgter Betätigung also entgegen der Betätigungsrichtung B wieder zurückgestellt wird.

Ein solches Federelement 136 kann für eine vereinfachte Bedienung vorteilhaft sein. Auf ein solches Federelement 136 kann aber auch verzichtet werden. Beim Ansetzen der Gehäusebaugruppe 10 an die Gehäusebaugruppe 14 in die Steckrichtung E wird ein Nutzer üblicherweise, sollte das Betätigungselement 12 sich nicht in seiner der Verriegelungsstellung des Verriegelungselements 13 zugeordneten Ausgangstellung befinden, auf den Kopf 120 des Betätigungselements 12 drücken und das Betätigungselement 12 somit in die der Verrieglungsstellung des Verriegelungselements 13 zugeordnete Stellung bringen.

Dadurch, dass das Verriegelungselement 13 einstückig und integral mit der Gehäusewandung 101 geformt ist und zudem das Betätigungselement 12 einfach aufgebaut und einfach zu fertigen ist, ergibt sich eine Verriegelungseinrichtung 11 einfacher Bauform, bei zuverlässiger und fester Verbindung in einer aneinander angesetzten Stellung der Gehäusebaugruppen 10, 14 und bei einfacher, komfortabler Handhabung sowohl zum Verbinden der Gehäusebaugruppen 10, 14 miteinander als auch zum Entriegeln und Lösen der Gehäusebaugruppen 10, 14 voneinander.

Die Gehäusewandung 101 der Gehäusebaugruppe 10 und die Wandung 143 innerhalb der Stecköffnung 140 der Gehäusebaugruppe 14 können - quer zur Betätigungsrichtung B - eine solche Elastizität aufweisen, dass ein Anstecken der Gehäusebaugruppe 10 in die Steckrichtung E an die Gehäusebaugruppe 14 auch bei nicht betätigtem Betätigungselement 12 möglich ist. Insbesondere kann die Gehäusewandung 101 so geformt sein, dass das Verriegelungselement 13 bei in der Ausgangsstellung gemäß Fig. 12 und 13 befindlichem Betätigungselement 12 so ausweichen kann, dass das Verriegelungselement 13 an dem Rastabschnitt 142 vorbei bewegt werden kann, bis das Verriegelungselement 13 mit dem Rastabschnitt 142 in Eingriff schnappt.

Der der Erfindung zugrunde liegende Gedanke ist nicht auf die vorangehend geschilderten Ausführungsbeispiele beschränkt, sondern lässt sich auch in anderer Weise verwirklichen.

Eine Verriegelungseinrichtung der beschriebenen Art kann zum Verbinden ganz unterschiedlicher Gehäusebaugruppen miteinander Verwendung finden und ist insofern nicht auf eine mit einem Gehäusesockel zu verbindende Gehäusebaugruppe beschränkt. Eine Verriegelungseinrichtung der beschriebenen Art kann überall dort zum Verriegeln eingesetzt werden, wo Gehäusebaugruppen in einer aneinander angesetzten Stellung mit Wandungen einander zugewandt sind, sodass über ein Verrieglungselement eine verriegelnde Verbindung hergestellt werden kann.

### Bezugszeichenliste

- 1: Elektrisches Gerät
- 10: Gehäusebaugruppe (Modulgehäuse)
- 100: Steckabschnitt
- 101, 102: Wandung
- 103: Öffnung
- 104: Kopfseite
- 105: Gehäuseteil
- 106: Stützabschnitt
- 11: Verriegelungseinrichtung
- 12: Betätigungselement
- 120: Kopf
- 121: Schaftabschnitt
- 122: Fußabschnitt
- 123, 124: Wirkabschnitt
- 125: Sperrabschnitt
- 126: Fase
- 127, 128: Schenkel
- 129: Aussparung (Aufnahmenut)
- 129A: Boden
- 13: Verriegelungselement
- 130, 131: Seitenkante
- 132: Endkante
- 133, 134: Aussparung
- 135: Verbundenes Ende
- 136: Federelement
- 14: Gehäusebaugruppe (Sockelteil)
- 140: Stecköffnung
- 141: Befestigungseinrichtung
- 142: Rastabschnitt
- 143: Wandung
- 2: Tragschiene
- A: Anreihrichtung
- B: Betätigungsrichtung
- C: Entsperrrichtung
- E: Steckrichtung

## Patentansprüche

1. Elektrisches Gerät (1), mit einer ersten Gehäusebaugruppe (14), einer eine Gehäusewandung (101) aufweisenden, zweiten Gehäusebaugruppe (10) und einer Verriegelungseinrichtung (11), wobei die erste Gehäusebaugruppe (14) und die zweite Gehäusebaugruppe (10) entlang einer Steckrichtung (E) aneinander ansetzbar und in einer aneinander angesetzten Stellung über die Verriegelungseinrichtung (11) miteinander verriegelt sind, wobei die Verriegelungseinrichtung (11) ein entlang einer Betätigungsrichtung (B) verstellbar an der zweiten Gehäusebaugruppe (10) angeordnetes Betätigungselement (12) und ein mit dem Betätigungselement (12) wirkverbundenes, verstellbar mit der Gehäusewandung (101) verbundenes Verriegelungselement (13) aufweist, wobei das Verriegelungselement (13) ausgebildet ist, in der aneinander angesetzten Stellung der Gehäusebaugruppen (10, 14) die erste Gehäusebaugruppe (14) und die zweite Gehäusebaugruppe (10) miteinander zu verriegeln, und durch Verstellen des Betätigungselements (12) in die Betätigungsrichtung (B) zu der Gehäusewandung (101) in eine quer zur Betätigungsrichtung (B) gerichtete Entsperrrichtung (C) zu der Gehäusewandung (101) verstellbar ist, um die Verriegelung zu lösen,
wobei
das Verriegelungselement (13) einstückig mit der Gehäusewandung (101) und als Lasche an der Gehäusewandung (101) geformt ist,
**dadurch gekennzeichnet, dass**
das Betätigungselement (12) zwei Wirkabschnitte (123, 124) aufweist, die an parallel zueinander erstreckten Seitenkanten (130, 131) des Verriegelungselements (13) verschiebbar geführt sind.

2. Elektrisches Gerät (1) nach Anspruch 1, **dadurch gekennzeichnet, dass** das Verriegelungselement (13) elastisch zu der Gehäusewandung (101) verstellbar ist.

3. Elektrisches Gerät (1) nach einem der vorangehenden Ansprüche, **dadurch gekennzeichnet, dass** das Verriegelungselement (13) in einer Verriegelungsstellung eine erste Stellung zu der Gehäusewandung (101) einnimmt und durch Verstellen des Betätigungselements (12) in eine Entriegelungsstellung verstellbar ist, in der das Verriegelungselement (13) relativ zur Verriegelungsstellung in die Entsperrrichtung (C) zu der Gehäusewandung (101) bewegt ist.

4. Elektrisches Gerät (1) nach Anspruch 3, **dadurch gekennzeichnet, dass** das Verriegelungselement (13) an einem verbundenen Ende (135) mit der Gehäusewandung (101) verbunden ist und in der Verriegelungsstellung mit einer von dem verbundenen Ende abliegenden Endkante (132) mit der ersten Gehäusebaugruppe (14) verriegelbar ist.

5. Elektrisches Gerät (1) nach Anspruch 3 oder 4, **dadurch gekennzeichnet, dass** das Betätigungselement (12) einen Sperrabschnitt (125) ausweist, der in der Verriegelungsstellung mit der Endkante (132) derart wechselwirkt, dass der Sperrabschnitt (125) ein Bewegen der Endkante (132) in die Entsperrrichtung (C) relativ zur Gehäusewandung (101) sperrt.

6. Elektrisches Gerät (1) nach Anspruch 5, **dadurch gekennzeichnet, dass** der Sperrabschnitt (125), betrachtet in die Entsperrrichtung (C), in der Verriegelungsstellung hinter der Endkante (132) angeordnet ist.

7. Elektrisches Gerät (1) nach Anspruch 5 oder 6, **dadurch gekennzeichnet, dass** der Sperrabschnitt (125) durch Verstellen des Bestätigungselements (12) relativ zur Endkante (132) des Verriegelungselements (13) bewegbar ist.

8. Elektrisches Gerät (1) nach einem der Ansprüche 5 bis 7, **dadurch gekennzeichnet, dass** der Sperrabschnitt (125) an einer entgegen der Betätigungsrichtung (B) weisenden Stirnseite eine Fase aufweist.

9. Elektrisches Gerät (1) nach einem der vorangehenden Ansprüche, **dadurch gekennzeichnet, dass** das Betätigungselement (12) entlang der Betätigungsrichtung (B) linear verschiebbar an der zweiten Gehäusebaugruppe (10) geführt ist.

10. Elektrisches Gerät (1) nach einem der vorangehenden Ansprüche, **dadurch gekennzeichnet, dass** die zweite Gehäusebaugruppe (10) in die Steckrichtung (E) an die erste Gehäusebaugruppe (14) ansetzbar ist, wobei die Betätigungsrichtung (B) zum Entriegeln des Verriegelungselements (13) entgegen der Steckrichtung (E) gerichtet ist.

11. Elektrisches Gerät (1) nach einem der vorangehenden Ansprüche, **dadurch gekennzeichnet, dass** das Betätigungselement (12) zumindest einen Wirkabschnitt (123, 124) aufweist, der an zumindest einer Seitenkante (130, 131) des Verriegelungselements (13) verschiebbar geführt ist.

12. Elektrisches Gerät (1) nach einem der vorangehenden Ansprüche, **gekennzeichnet durch** ein Federelement (136), dass das Betätigungselement (12) gegenüber der zweiten Gehäusebaugruppe (10) entgegen der Betätigungsrichtung (B) vorspannt.

13. Elektrisches Gerät (1) nach einem der vorangehenden Ansprüche, **dadurch gekennzeichnet, dass** die erste Gehäusebaugruppe (14) eine Stecköffnung (140) und die zweite Gehäusebaugruppe (10) einen Steckabschnitt (100) aufweisen, wobei der Steckabschnitt (100) zum Ansetzen der ersten Gehäusebaugruppe (14) und der zweiten Gehäusebaugruppe (10) aneinander in die Stecköffnung (140) einsteckbar ist.

14. Elektrisches Gerät (1) nach Anspruch 13, **dadurch gekennzeichnet, dass** das Verriegelungselement (13) an dem Steckabschnitt (100) geformt ist.

15. Elektrisches Gerät (1) nach Anspruch 13 oder 14, **dadurch gekennzeichnet, dass** die erste Gehäusebaugruppe (14) eine der Stecköffnung (140) zugewandte Wandung (143) und einen an der Wandung (143) geformten Rastabschnitt (142) aufweist, mit dem das Verriegelungselement (13) in der aneinander angesetzten Stellung der Gehäusebaugruppen (10, 14) zum Verriegeln in Eingriff ist.

16. Elektrisches Gerät (1) nach einem der Ansprüche 13 bis 15, **dadurch gekennzeichnet, dass** das Betätigungselement (12) einen Kopf (120) aufweist, der im Bereich einer von dem Steckabschnitt (100) abgewandten Kopfseite (104) der zweiten Gehäusebaugruppe (10) angeordnet ist.

## Claims

1. Electrical device (1), comprising a first housing assembly (14), a second housing assembly (10) which has a housing wall (101), and a locking device (11), wherein the first housing assembly (14) and the second housing assembly (10) can be attached to each other along a plug-in direction (E) and are locked to each other via the locking device (11) in a position in which they are attached to each other, wherein the locking device (11) has an actuating element (12) which is arranged adjustably along an actuating direction (B) on the second housing assembly (10) and a locking element (13) which is operatively connected to the actuating element (12) and adjustably connected to the housing wall (101), wherein the locking element (13) is designed to lock the first housing assembly (14) and the second housing assembly (10) to each other in the position in which the housing assemblies (10, 14) are attached to each other, and can be adjusted in relation to the housing wall (101) in an unlocking direction (C) directed transversely to the actuating direction (B) in order to release the locking mechanism by adjusting the actuating element (12) in the actuating direction (B) in relation to the housing wall (101), wherein the locking element (13) is formed in one piece with the housing wall (101) and as a tab on the housing wall (101), **characterized in that** the actuating element (12) has two active portions (123, 124), which are displaceably guided on side edges (130, 131) of the locking element (13) that extend parallel to each other.

2. Electrical device (1) according to Claim 1, **characterized in that** the locking element (13) is elastically adjustable in relation to the housing wall (101).

3. Electrical device (1) according to either of the preceding claims, **characterized in that** the locking element (13) assumes a first position in relation to the housing wall (101) in a locking position and by adjusting the actuating element (12) can be adjusted to an unlocking position in which the locking element (13) is moved in relation to the housing wall (101) in the unblocking direction (C) relative to the locking position.

4. Electrical device (1) according to Claim 3, **characterized in that** the locking element (13), at a connected end (135), is connected to the housing wall (101) and, by way of an end edge (132) remote from the connected end, can be locked to the first housing assembly (14) in the locking position.

5. Electrical device (1) according to Claim 3 or 4, **characterized in that** the actuating element (12) shows a blocking portion (125), which in the locking position interacts with the end edge (132) in such a way that the blocking portion (125) blocks movement of the end edge (132) relative to the housing wall (101) in the unblocking direction (C).

6. Electrical device (1) according to Claim 5, **characterized in that** the blocking portion (125), viewed in the unblocking direction (C), is arranged behind the end edge (132) in the locking position.

7. Electrical device (1) according to Claim 5 or 6, **characterized in that** the blocking portion (125) can be moved by adjusting the confirming element (12) relative to the end edge (132) of the locking element (13).

8. Electrical device (1) according to any of Claims 5 to 7, **characterized in that** the blocking portion (125) has a chamfer on an end side facing opposite to the actuating direction (B).

9. Electrical device (1) according to any of the preceding claims, **characterized in that** the actuating element (12) is guided linearly displaceably on the second housing assembly (10) along the actuating direction (B).

10. Electrical device (1) according to any of the preceding claims, **characterized in that** the second housing assembly (10) can be attached to the first housing assembly (14) in the plug-in direction (E), wherein the actuating direction (B) is directed opposite to the plug-in direction (E) in order to unlock the locking element (13).

11. Electrical device (1) according to any of the preceding claims, **characterized in that** the actuating element (12) has at least one active portion (123, 124) which is displaceably guided on at least one side edge (130, 131) of the locking element (13).

12. Electrical device (1) according to any of the preceding claims, **characterized by** a spring element (136) that preloads the actuating element (12) opposite to the actuating direction (B) in relation to the second housing assembly (10).

13. Electrical device (1) according to any of the preceding claims, **characterized in that** the first housing assembly (14) has a plug-in opening (140) and the second housing assembly (10) has a plug-in portion (100), wherein the plug-in portion (100) can be inserted into the plug-in opening (140) in order to attach the first housing assembly (14) and the second housing assembly (10) to each other.

14. Electrical device (1) according to Claim 13, **characterized in that** the locking element (13) is formed on the plug-in portion (100).

15. Electrical device (1) according to Claim 13 or 14, **characterized in that** the first housing assembly (14) has a wall (143) facing the plug-in opening (140) and a latching portion (142) formed on the wall (143) with which the locking element (13), for locking purposes, engages in the position in which the housing assemblies (10, 14) are attached to each other.

16. Electrical device (1) according to any of Claims 13 to 15, **characterized in that** the actuating element (12) has a head (120) which is arranged in the region of a head side (104) of the second housing assembly (10), the head side being averted from the plug-in portion (100).

## Revendications

1. Appareil électrique (1), comprenant un premier sous-ensemble de boîtier (14), un second sous-ensemble de boîtier (10) qui présente une paroi de boîtier (101) et un dispositif de verrouillage (11), le premier sous-ensemble de boîtier (14) et le second sous-ensemble de boîtier (10) pouvant être fixés l'un à l'autre dans une direction d'enfichage (E), et étant verrouillés l'un à l'autre dans une position dans laquelle ils sont fixés l'un à l'autre au moyen du dispositif de verrouillage (11), le dispositif de verrouillage (11) comportant un élément d'actionnement (12) qui est disposé sur le second sous-ensemble de boîtier (10) de manière qu'il soit mobile dans une direction d'actionnement (B), et un élément de verrouillage (13) qui est relié de façon mobile à la paroi de boîtier (101) et relié de façon fonctionnelle à l'élément d'actionnement (12), l'élément de verrouillage (13) étant conçu pour verrouiller le premier sous-ensemble de boîtier (14) et le second sous-ensemble de boîtier (10) dans une position des sous-ensembles de boîtier (10, 14) dans laquelle ils sont fixés l'un à l'autre, et, pour le déverrouillage, pouvant être déplacé par rapport à la paroi de boîtier (101) dans une direction de déblocage (C) orientée transversalement à la direction d'actionnement (B), par le déplacement de l'élément d'actionnement (12) par rapport à la paroi de boîtier (101) dans la direction d'actionnement (B), l'élément de verrouillage (13) étant formé d'un seul tenant avec la paroi de boîtier (101) et sous forme de languette sur la paroi de boîtier (101), **caractérisé en ce que** l'élément d'actionnement (12) présente deux sections fonctionnelles (123, 124) qui sont guidées de manière coulissante sur des bords latéraux (130, 131) de l'élément de verrouillage (13) s'étendant parallèlement l'un à l'autre.

2. Appareil électrique (1) selon la revendication 1, **caractérisé en ce que** l'élément de verrouillage (13) peut être ajusté élastiquement par rapport à la paroi de boîtier (101).

3. Appareil électrique (1) selon l'une quelconque des revendications précédentes, **caractérisé en ce que** l'élément de verrouillage (13) adopte une première position par rapport à la paroi de boîtier (101) dans une position de verrouillage et peut être déplacé par déplacement de l'élément d'actionnement (12) dans une position de déverrouillage dans laquelle l'élément de verrouillage (13) est déplacé par rapport à la position de verrouillage dans la direction de déblocage (C) par rapport à la paroi de boîtier (101).

4. Appareil électrique (1) selon la revendication 3, **caractérisé en ce que** l'élément de verrouillage (13) est relié à la paroi de boîtier (101) au niveau d'une extrémité connectée (135) et dans la position de verrouillage, est verrouillable avec le premier sous-ensemble de boîtier (14) par une arête d'extrémité (132) éloignée de l'extrémité connectée.

5. Appareil électrique (1) selon la revendication 3 ou 4, **caractérisé en ce que** l'élément d'actionnement (12) montre une section de blocage (125) qui interagit avec l'arête d'extrémité (132) dans la position de verrouillage de telle sorte que la section de blocage (125) bloque un mouvement de l'arête d'extrémité (132) dans la direction de déblocage (C) par rapport à la paroi de boîtier (101).

6. Appareil électrique (1) selon la revendication **5, caractérisé en ce que** la section de blocage (125), vue dans la direction de déblocage (C), est agencée à l'arrière de l'arête d'extrémité (132) dans la position de verrouillage.

7. Appareil électrique (1) selon la revendication 5 ou **6, caractérisé en ce que** la section de blocage (125) peut être déplacée par rapport à l'arête d'extrémité (132) de l'élément de verrouillage (13) par un ajustement de l'élément de confirmation (12).

8. Appareil électrique (1) selon l'une quelconque des revendications 5 à 7, **caractérisé en ce que** la section de blocage (125) présente un chanfrein sur une face avant orientée en sens opposé à la direction d'actionnement (B).

9. Appareil électrique (1) selon l'une quelconque des revendications précédentes, **caractérisé en ce que** l'élément d'actionnement (12) est guidé de manière linéairement coulissante sur le second sous-ensemble de boîtier (10) dans la direction d'actionnement (B).

10. Appareil électrique (1) selon l'une quelconque des revendications précédentes, **caractérisé en ce que** le second sous-ensemble de boîtier (10) peut être fixé au premier sous-ensemble de boîtier (14) dans la direction d'enfichage (E), la direction d'actionnement (B) destiné à déverrouiller l'élément de verrouillage (13) étant orientée en sens opposé à la direction d'enfichage (E).

11. Appareil électrique (1) selon l'une quelconque des revendications précédentes, **caractérisé en ce que** l'élément d'actionnement (12) présente au moins une section fonctionnelle (123, 124) qui est guidée de manière coulissante sur au moins un bord latéral (130, 131) de l'élément de verrouillage (13).

12. Appareil électrique (1) selon l'une quelconque des revendications précédentes, **caractérisé par** un élément à ressort (136) qui précontraint l'élément d'actionnement (12) par rapport au second sous-ensemble de boîtier (10) en sens opposé à la direction d'actionnement (B).

13. Appareil électrique (1) selon l'une quelconque des revendications précédentes, **caractérisé en ce que** le premier sous-ensemble de boîtier (14) présente une ouverture d'enfichage (140) et le second sous-ensemble de boîtier (10) présente une section d'enfichage (100), la section d'enfichage (100) pouvant être enfichée dans l'ouverture d'enfichage (140) pour l'assemblage du premier sous-ensemble de boîtier (14) et du second sous-ensemble de boîtier (10).

14. Appareil électrique (1) selon la revendication 13, **caractérisé en ce que** l'élément de verrouillage (13) est formé sur la section d'enfichage (100).

15. Appareil électrique (1) selon la revendication 13 ou 14, **caractérisé en ce que** le premier sous-ensemble de boîtier (14) présente une paroi (143) adjacente à l'ouverture d'enfichage (140) et une section de verrouillage par encliquetage (142) formée sur la paroi (143) avec laquelle l'élément de verrouillage (13) est en prise pour le verrouillage dans la position assemblée des sous-ensembles de boîtier (10, 14).

16. Appareil électrique (1) selon l'une quelconque des revendications 13 à 15, **caractérisé en ce que** l'élément d'actionnement (12) présente une tête (120) qui est agencée dans la zone d'un côté de tête (104) du second sous-ensemble de boîtier (10) qui est tournée à l'opposé de la section d'enfichage (100).
